(19) **Europäisches Patentamt**

**European Patent Office**

**Office européen des brevets**

(11) **EP 0 689 315 B1**

(12) **FASCICULE DE BREVET EUROPEEN**

(45) Date de publication et mention
de la délivrance du brevet:
**22.03.2000 Bulletin 2000/12**

(51) Int Cl.7: **H04L 7/033**

(21) Numéro de dépôt: **95401435.3**

(22) Date de dépôt: **19.06.1995**

(54) **Dispositif comparateur de phase**

Phasenkomparator

Phase comparator

(84) Etats contractants désignés:
**DE FR GB IT**

(30) Priorité: **22.06.1994 FR 9407662**

(43) Date de publication de la demande:
**27.12.1995 Bulletin 1995/52**

(73) Titulaire: **MHS**
**44087 Nantes Cédex 03 (FR)**

(72) Inventeur: **Neron, Christophe**
**F-44300 Nantes (FR)**

(74) Mandataire: **Fréchède, Michel et al**
**Cabinet Plasseraud**
**84, rue d'Amsterdam**
**F-75440 Paris Cédex 09 (FR)**

(56) Documents cités:
**EP-A- 0 286 329**    **EP-A- 0 500 473**
**US-A- 4 535 459**

- **JOURNAL OF LIGHTWAVE TECHNOLOGY,**
  **vol.3, no.6, Décembre 1985 pages 1312 - 1314**
  **C.H.HOGGE 'A SELF CORRECTING CLOCK**
  **RECOVERY CIRCUIT'**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

Dans les techniques relatives à la transmission ou au traitement de signaux numériques, il est indispensable d'assurer une transmission ou un traitement à haut débit en parfait synchronisme avec un signal d'horloge de référence.

A cet effet, les circuits permettant ce type d'opérations nécessitent la mise en oeuvre de circuits récupérateurs de rythme.

L'amélioration des performances de ces derniers circuits consiste, selon les techniques actuelles, soit à réduire les effets des différentes sources de bruit, notamment de bruit de phase, présentes dans ces circuits, afin d'en améliorer les performances relativement au phénomène de "*gigue*" connu sous la dénomination de "*jitter*" en vocable anglo-saxon, soit à minimiser les erreurs de transmission en améliorant la tolérance au bruit du circuit récupérateur de rythme. Cette dernière opération est effectuée lors de la resynchronisation des données numériques, constituées par une suite d'éléments binaires, au moyen d'une bascule bistable synchronisée sur le signal d'horloge de référence et en maintenant le front actif du signal d'horloge en milieu de chaque élément binaire. Une telle mesure implique la synchronisation parfaite du front actif du signal d'horloge et de la demi-période du flux d'éléments binaires.

Des circuits récupérateurs de rythme de ce type ont été notamment décrits dans l'article intitulé "*A self correcting Clock Recovery Circuit*" publié par Charles R. HOGGE, dans la revue technique JOURNAL OF LIGHTWAVE TECHNOLOGY, Vol. LT-3, No.6 Décembre 1985.

Le circuit décrit par l'article précité fournit un excellent résultat car il remplit simultanément les fonctions de régénération et de resynchronisation des données numériques ainsi qu'une auto-correction du maintien en milieu de bit du front actif de l'horloge locale de référence.

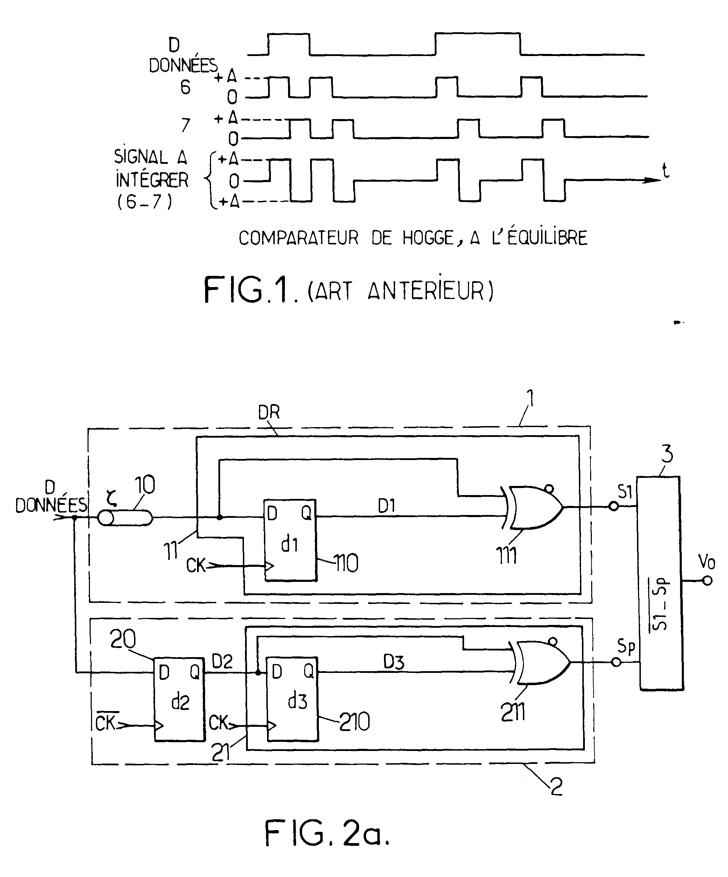

Toutefois, une analyse des signaux de sortie 6 et 7 en entrée du comparateur de sortie, ainsi que représenté en figure 1 relative à l'art antérieur correspondant, montre que ces derniers sont, à l'équilibre de phase, décalés de 180°. En conséquence, le signal à intégrer [6-7], délivré par le comparateur de sortie précité, possède une forte ondulation crête à crête, d'amplitude 2A, lorsque l'équilibre de phase est acquis.

Le signal à intégrer précité, ou signal différentiel, possède donc une amplitude crête à crête importante et une fréquence maximale égale à la fréquence élément binaire ou fréquence bit. Un tel signal est susceptible de constituer une source de "*gigue*" très importante dans le circuit, sauf à prévoir un traitement de filtrage très soigné. Le phénomène de "*gigue*" précité peut donc se révéler très gênant, notamment dans les dispositifs de transmission constitués par des éléments successifs en cascade, pour lesquels il est bien connu que le phénomène de "*gigue*" s'accumule et augmente systématiquement le long de la chaîne de transmission.

La présente invention a pour objet la mise en oeuvre d'un dispositif comparateur de phase conservant les avantages obtenus par le circuit décrit dans l'article précité tout en éliminant ou réduisant sensiblement la contribution de celui-ci au phénomène de "*gigue*".

Le dispositif comparateur de phase entre transitions d'un signal numérique formé par une suite de bits {ak} et un signal d'horloge Ck à la fréquence élément binaire de ce signal numérique, objet de la présente invention, est remarquable en ce qu'il comprend une première voie de détection permettant, à partir du signal d'horloge Ck et du signal numérique, d'engendrer un signal numérique retardé d'une valeur de retard $\tau$, $0 < \tau < T$, où T désigne la période du signal numérique, cette première voie de détection comportant en outre un circuit générateur à chaque transition d'une première impulsion dont la durée est variable, proportionnelle au déphasage entre le signal numérique retardé et le signal d'horloge. Une deuxième voie de détection est prévue, laquelle permet, à partir du signal d'horloge et du signal numérique, d'engendrer à chaque transition du signal numérique une deuxième impulsion de durée constante égale à la demi-période du signal d'horloge. Un circuit de calcul de la valeur moyenne, sur au moins un cycle du signal d'horloge, de la différence algébrique entre la première et la deuxième impulsion délivre un signal de comparaison de phase entre signal numérique et signal d'horloge de valeur nulle pour un déphasage nul et un centrage exact de l'impulsion formée par deux transitions consécutives du signal numérique retardé sur un front montant ou descendant du signal d'horloge et de valeur positive ou négative pour un déphasage d'avance respectivement de retard du signal d'horloge par rapport au signal numérique retardé.

Le dispositif comparateur de phase, objet de la présente invention, trouve application à la réalisation de circuits électroniques de traitement de signaux numériques, notamment sous forme de circuits intégrés.

Il sera mieux compris dans ses éléments structurels et/ou fonctionnels à la lecture de la description et à l'observation des dessins ci-après dans lesquels, outre la figure 1 relative à l'art antérieur,

- la figure 2a représente le schéma d'un dispositif comparateur de phase, objet de la présente invention,
- les figures 2b, 2c et 2d représentent des chronogrammes des signaux mis en oeuvre par le dispositif représenté en figure 2a dans le cas d'une avance, d'un retard respectivement d'une égalité de phase d'un signal d'horloge par rapport à un signal numérique de données, retardé par rapport à un signal numérique de données d'origine,
- la figure 3a représente une variante de réalisation du dispositif comparateur de phase représenté en figure 2a, en vue d'une application à haute fréquence ou haut débit de données,
- la figure 3b représente un chronogramme des signaux mis en oeuvre par le dispositif de la figure 3a,

- la figure 4 représente une application particulière avantageuse du comparateur de phase représenté en figure 2a ou 3a à la réalisation d'une boucle à verrouillage de phase permettant, à partir d'un signal numérique d'entrée, de restaurer un signal d'horloge local parfaitement synchrone du signal numérique d'entrée,
- les figures 5a et 5b sont relatives à un mode de réalisation avantageux d'un circuit générateur du signal de comparaison de phase.

Une description plus détaillée d'un dispositif comparateur de phase entre transitions d'un signal numérique, objet de la présente invention, sera maintenant donnée en liaison avec la figure 2a.

D'une manière générale, on indique que le signal numérique est un signal de données, référencé par la lettre D, formé par une suite de bits ou éléments binaires, notée { ak} . Bien entendu, on dispose pour la mise en oeuvre du dispositif comparateur de phase, objet de la présente invention, d'un signal d'horloge, noté Ck, ce signal d'horloge étant un signal à la fréquence bit ou fréquence élément binaire du signal numérique précité, réputé présenter une période correspondant à la durée de chaque bit, désignée par T. A priori, et en raison des vicissitudes de mise en oeuvre des circuits électroniques, le signal numérique d'entrée, ou signal numérique d'origine D, et le signal d'horloge Ck peuvent présenter un phénomène de "*gigue*" de phase néfaste au traitement et à la transmission correcte des données véhiculées par le signal numérique d'entrée précité.

Ainsi qu'on l'a représenté en figure 2a, on indique que le dispositif comparateur de phase, objet de la présente invention, comprend une première voie de détection, notée 1, permettant, à partir du signal d'horloge Ck et du signal numérique D, d'engendrer un signal numérique retardé, noté DR, d'une valeur de retard $\tau$ comprise entre $0 < \tau < T$. Le signal numérique retardé DR peut être engendré par l'intermédiaire d'un circuit de retard 10, lequel sera décrit plus en détail ultérieurement dans la description.

La première voie 1 comporte en outre un circuit 11 générateur à chaque transition du signal numérique D d'une première impulsion dont la durée est variable, proportionnelle au déphasage entre le signal numérique retardé DR et le signal d'horloge Ck. Ce signal est noté $S_1$ sur la figure 2a, la sortie du circuit générateur 11 constituant en fait la sortie de la première voie de détection 1 précédemment mentionnée.

Le dispositif comparateur, selon l'invention, comporte en outre une deuxième voie de détection, notée 2, permettant, à partir du signal d'horloge Ck et du signal numérique D, d'engendrer à chaque transition du signal numérique précité, une deuxième impulsion calibrée de durée constante, égale à la demi-période du signal d'horloge Ck. La deuxième impulsion calibrée est notée Sp sur la figure 2a.

Enfin, un circuit de calcul 3 de la valeur moyenne de la différence entre la première et la deuxième impulsion est prévu, ce circuit de calcul 3 délivrant un signal de comparaison de phase $V_0$ entre signal numérique retardé DR et signal d'horloge de valeur nulle pour un déphasage nul et un centrage exact de l'impulsion formée par deux transitions consécutives du signal numérique retardé DR sur un front montant ou descendant du signal d'horloge. Le signal de comparaison de phase $V_0$ a, au contraire, une valeur moyenne positive, respectivement négative, pour un déphasage d'avance respectivement de retard du signal d'horloge Ck par rapport au signal numérique retardé DR précité.

Ainsi qu'on l'a en outre représenté en figure 2a, on indique que la première voie de détection 1 comprend, connectés en cascade, le circuit de retard 10 permettant d'introduire la valeur de retard $\tau$ dans les conditions précitées sur le signal numérique d'entrée D pour engendrer le signal numérique retardé DR, et le circuit 11 générateur de la première impulsion $S_1$. D'une manière générale, on indique que le circuit de retard 10 peut être réalisé soit par un circuit dit externe, c'est-à-dire par un circuit de type ligne à retard analogique, soit, au contraire, par un circuit interne lorsque le circuit de retard 10 est réalisé par exemple par l'intermédiaire de portes logiques successives, entraînant chacune un retard élémentaire de valeur déterminée. Dans ce deuxième mode de réalisation, le circuit de retard 10 est dit interne en raison du fait que les portes logiques constitutives de ce dernier peuvent être intégrées sur un même substrat pour réaliser le dispositif comparateur de phase, objet de la présente invention, tel que représenté en figure 2a.

En outre, la première voie de détection 1 comprend le circuit 11 générateur de la première impulsion S1, ce circuit comprenant par exemple un premier circuit logique 111 de type OU exclusif, recevant sur une première entrée le signal numérique retardé DR, et une bascule bistable synchronisée, notée 110, cette bascule étant synchronisée sur le signal d'horloge Ck. Ainsi, la bascule bistable synchronisée 110 reçoit sur son entrée d'horloge le signal d'horloge Ck, sur son entrée D le signal numérique retardé DR, et délivre à sa sortie Q un signal numérique retardé synchronisé, noté $D_1$, lequel est directement délivré à la deuxième entrée du premier circuit logique de type OU exclusif 111. Ce dernier délivre la première impulsion $S_1$ en sortie de la première voie de détection 1.

Ainsi qu'on l'a également représenté sur la figure 2a, la deuxième voie de détection 2 comprend, connectés en cascade, un circuit générateur 20 d'un signal numérique décalé d'une demi-période par rapport au signal numérique retardé synchronisé à partir du signal numérique d'entrée D. En sortie du circuit générateur 20, est connecté un circuit générateur, à partir du signal numérique retardé d'une demi-période délivré par le circuit générateur 20, de la deuxième impulsion $S_p$, ce circuit générateur de la deuxième impulsion portant la référence 21 comprenant, de manière semblable au circuit 11 de la première voie, un deuxième circuit logique de type OU exclusif, noté 211, recevant sur une première entrée le signal numérique décalé d'une demi-période, signal noté $D_2$, et une bascule bistable synchronisée, notée 210, cette bascule étant synchronisée sur le signal d'horloge Ck. La bascule bistable 210 reçoit sur son entrée D le signal logique décalé d'une demi-période, noté $D_2$, et sur son entrée d'horloge, le signal Ck précité. La sortie Q de la deuxième bascule bistable synchronisée 210 délivre un signal $D_3$ à une deuxième entrée de la deuxième porte OU exclusif 211.

En outre, on indique que le circuit générateur 20 du signal numérique décalé d'une demi-période $D_2$ par rapport au signal numérique retardé synchronisé peut être formé par une bascule bistable synchronisée sur le signal d'horloge complémenté $\overline{Ck}$. La bascule synchronisée précitée reçoit sur son entrée D le signal numérique d'entrée D, et sur son entrée d'horloge le signal numérique complémenté $\overline{Ck}$, et délivre sur sa sortie Q le signal numérique décalé d'une demi-période, noté $D_2$.

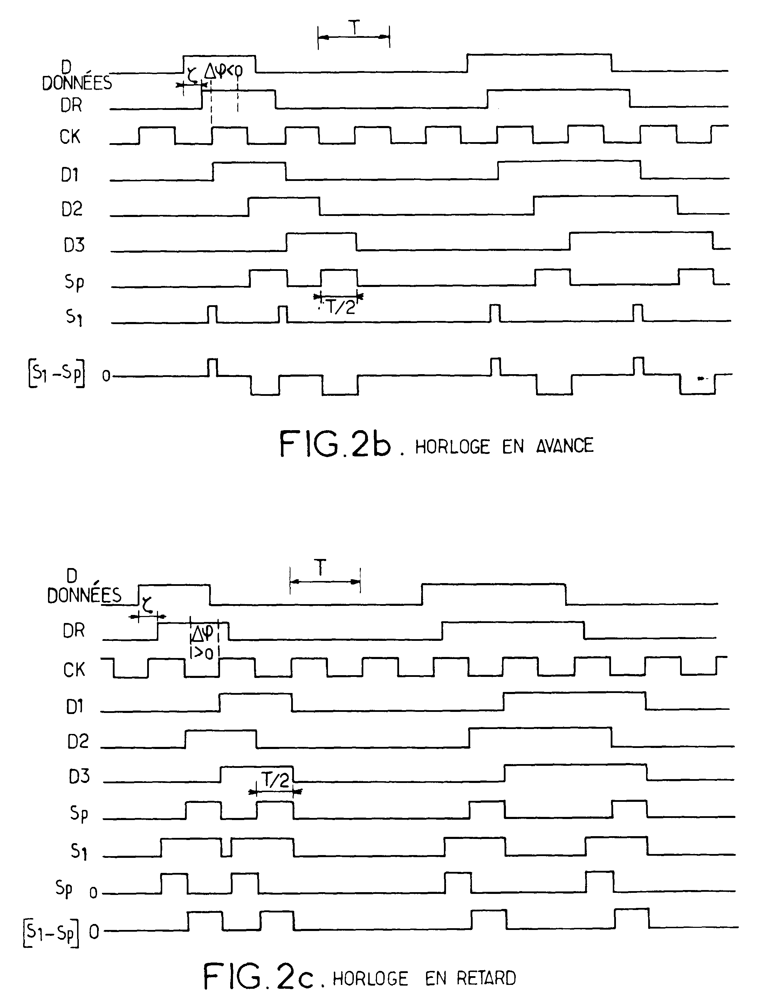

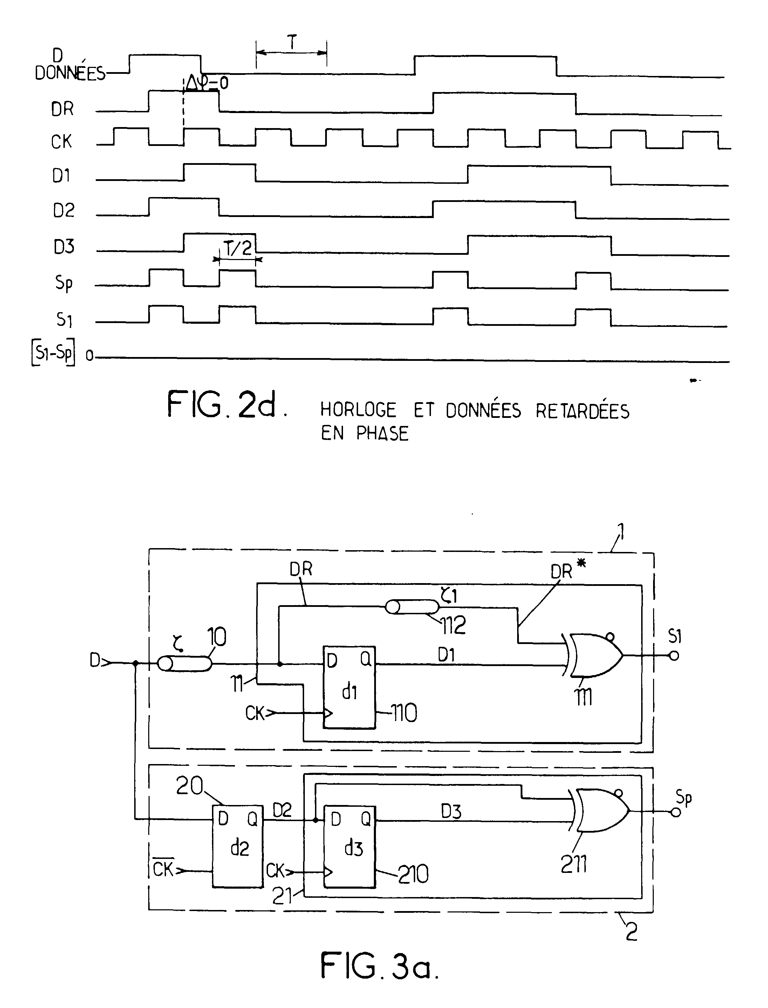

Le fonctionnement du dispositif, objet de la présente invention, tel que représenté en figure 2a, sera explicité en liaison avec les figures 2b, 2c et 2d ci-après.

- Figure 2b : horloge en avance de phase.

Dans le cas de la figure 2b précitée, on indique que le chronogramme représenté correspond au cas où l'horloge Ck est en avance de phase par rapport au centre des deux transitions successives, représentatives par exemple de la transmission d'éléments binaires de valeurs successives 0, 1, 0. Dans ce cas, le front montant du signal d'horloge, considéré comme le front actif, présente une avance de phase $\Delta\phi < 0$ par rapport au centre de l'impulsion formée par les deux transitions précitées. Le signal $D_2$, délivré par la bascule bistable synchronisée 20 sur le signal d'horloge complémenté $\overline{Ck}$, est décalé en retard par rapport au signal $D_1$, le signal $D_2$ étant délivré par la bascule bistable synchronisée 20 pour la valeur 1 du signal d'horloge complémenté $\overline{Ck}$, c'est-à-dire la valeur 0 du signal d'horloge Ck.

La valeur moyenne de la deuxième impulsion $S_p$ est supérieure à la valeur moyenne de la première impulsion $S_1$ en raison du déphasage $\Delta\phi$ négatif, représenté entre le signal numérique retardé DR et le signal d'horloge Ck. La première impulsion $S_1$ délivrée par le premier circuit OU exclusif 111, a pour valeur, pour chacune des transitions du signal numérique d'entrée D et donc du signal numérique retardé DR, le décalage entre les fronts montants du signal numérique retardé DR et du signal $D_1$, respectivement entre les fronts descendants de ces deux mêmes signaux, ainsi que représenté sur la figure 2b. Dans ces conditions, la valeur moyenne de la différence $S_1 - S_p$, différence algébrique de la première et de la deuxième impulsion, la deuxième impulsion ayant toujours pour valeur la demi-période T/2, est donc négative.

- Figure 2c : horloge en retard de phase.

Dans le cas où, au contraire, le signal d'horloge, c'est-à-dire le front montant de celui-ci, est en retard par rapport au centre de l'impulsion formé par les deux transitions successives précitées $\Delta\phi > 0$, représenté sur la figure 2c précité, le signal $D_2$ délivré par la bascule bistable synchronisée 20 est en avance d'une demi-période T/2 par rapport au signal $D_1$ délivré par la bascule bistable 110. En d'autres termes, le signal $D_1$ délivré par la bascule synchronisée précitée 110 est en retard de plus d'une demi-période par rapport au signal numérique retardé DR, $\Delta\phi > 0$, et le signal $S_1$ résultat du OU exclusif entre ces deux signaux présente donc une durée à l'état haut supérieure à la demi-période T/2. Dans ce cas, la valeur moyenne de la deuxième impulsion $S_p$ dont la durée est fixe, calibrée et égale à T/2, est inférieure à celle de la première impulsion $S_1$, ce qui indique que le signal d'horloge Ck est en retard par rapport au signal numérique retardé DR. La valeur moyenne de la différence entre la première et la deuxième impulsion $S_1 - S_p$ est cette fois positive.

- Figure 2d : horloge et données retardées DR en phase.

Dans le cas de la figure 2d précitée, le signal d'horloge Ck et le signal numérique retardé DR sont en phase, le front montant du signal d'horloge étant exactement centré sur la demi-durée entre deux transitions. Le décalage de phase est alors nul, $\Delta\phi = 0$. Dans ce cas, et en référence au fonctionnement précédemment décrit dans le cas de l'avance ou du retard de phase, on comprend bien sûr que, par symétrie, la première impulsion $S_1$ a une durée égale à la demi-période T/2, cette durée étant donc égale à celle de la deuxième impulsion $S_p$. Les première et deuxième impulsions $S_1$ et $S_p$ ont exactement la même durée, et donc même valeur moyenne, et la valeur moyenne de la différence entre première et deuxième impulsion $S_1 - S_p$ est donc nulle. On constate en outre, contrairement aux comparateurs de phase de l'art antérieur tels que décrits dans l'article précédemment mentionné dans la description, que les signaux $S_1$ et $S_p$ sont exactement en phase. La différence obtenue pour le signal différentiel $S_1 - S_p$ est donc de valeur nulle, c'est-à-dire sans aucune ondulation à l'équilibre. Le dispositif objet de la présente invention permet donc d'améliorer notoirement les performances vis-à-vis du phénomène de "*gigue*", la contribution à ce phénomène étant ainsi sensiblement supprimée.

D'une manière générale, on indique que la valeur du retard $\tau$ apporté par le circuit 10 de la première voie de détection peut être choisie de manière arbitraire quelconque, pourvu que cette valeur soit différente de 0 ou T. La bascule bistable synchronisée 20, synchronisée sur le signal d'horloge complémenté $\overline{Ck}$, resynchronise en fait le signal de données sur un front descendant du signal d'horloge Ck.

Pour cette raison, lorsque le système est en équilibre en l'absence de déphasage, selon le chronogramme de la figure 2d, pour une valeur de retard $\tau = 0$, le front descendant du signal d'horloge Ck est aligné avec les transitions du signal numérique d'entrée. Une telle situation est susceptible d'entraîner des conflits lors de la resynchronisation par l'intermédiaire de la bascule bistable synchronisée 20. Pour assurer l'absence d'une telle situation, il suffit de prendre une valeur de retard $\tau$ supérieure au temps d'établissement de la bascule bistable synchronisée 20.

Si, au contraire, la valeur de retard $\tau = T$, on retrouve un phénomène semblable. Il est alors souhaitable d'assurer une valeur de retard $\tau$ inférieure à la durée de la période T diminuée du temps de maintien de la bascule bistable synchronisée 20. D'où la valeur précédemment mentionnée pour la valeur de retard $\tau$ précitée.

Une valeur optimale du retard $\tau$ est donnée par $\tau = T/2$. Cette valeur optimale permet d'introduire la marge de phase statique optimale, toute autre valeur $\tau \neq T/2 \in \, ]\,0,T\,[$ ne présentant pas cette caractéristique. Contrairement au comparateur de Hogge où la marge de phase est constante, la marge de phase statique n'est pas conservée sur toute la plage de durée possible de retard.

Dans un mode de réalisation pratique, on indique que les bascules bistables synchronisées portant la référence 110, 20 et 210, peuvent être réalisées de manière classique ou bien être constituées par deux bascules verrouillées, "*latches*" en langage anglo-saxon, et montées en cascade de type maître-esclave. Les sorties Q, $\overline{Q}$ de ces bascules peuvent alors être disponibles.

Les circuits de type OU exclusif 111 et 211 peuvent être réalisés par des circuits de type classique.

En première conclusion, on indique que le dispositif comparateur de phase, objet de la présente invention, permet de délivrer un signal de comparaison de phase, en l'absence de déphasage, issu d'une tension différentielle d'erreur présentant une ondulation crête nulle, ce qui bien entendu permet de diminuer sensiblement la contribution d'un tel circuit au phénomène de "*gigue*". En outre, on constate à l'observation des chronogrammes représentés en figures 2b, 2c et 2d, que le dispositif selon l'invention permet d'effectuer un centrage automatique des fronts montants du signal d'horloge Ck en milieu de bit, c'est-à-dire bien sûr en milieu des transitions correspondantes du signal numérique retardé DR en assurant ainsi une resynchronisation du signal de données retardé idéal sur le signal d'horloge précité. On indique en outre, en raison de la structure particulière du dispositif, objet de la présente invention, tel que représentée en figure 2a, que les signaux numériques engendrés par les sorties Q ou $\overline{Q}$ des bascules bistables synchronisées 110, 20, 210 correspondent aux signaux $D_1$, $D_2$ et $D_3$ ou à ces signaux complémentés et peuvent donc être utilisés comme tels pour constituer en fait un signal numérique d'entrée régénéré. Enfin, le fonctionnement du dispositif, objet de la présente invention, est indépendant de la valeur de la période d'horloge T.

Une description plus détaillée d'un dispositif comparateur de phase, conforme à l'objet de la présente invention, appliqué plus particulièrement à la transmission de signal numérique à haute fréquence ou à haut débit sera maintenant donnée en liaison avec la figure 3a.

Sur la figure précitée, on indique que les mêmes références représentent les mêmes éléments que dans le cas de la figure 2a précédente. Toutefois, la première entrée du premier circuit logique de type OU exclusif 111 de la première voie de détection 1 comprend un circuit de retard 112 permettant d'introduire une compensation, sur le signal numérique retardé DR, du temps de propagation et de transition introduit par la première bascule bistable synchronisée 110. Le circuit de retard 111 délivre en fait, sur l'entrée du premier circuit de type OU exclusif 111, un signal numérique retardé compensé, noté DR*.

D'une manière générale, on indique que, afin de compenser exactement les temps de propagation des différents signaux dans les différents circuits permettant la mise en oeuvre de la première et de la deuxième voie de détection 1,2, il est opportun que les différents éléments soient parfaitement appairés afin que ceux-ci présentent les mêmes temps de propagation pour de larges plages de conditions de fonctionnement en température, tension d'alimentation, par exemple. C'est le cas en particulier pour les circuits logiques de type OU exclusif 111 et 211.

En outre, on indique que le retard $\tau_1$ introduit par le circuit de retard 112 doit présenter les mêmes variations que le temps de propagation ou d'établissement de la bascule bistable synchronisée 110 pour engendrer le signal $D_1$, dans des conditions de fonctionnement semblables.

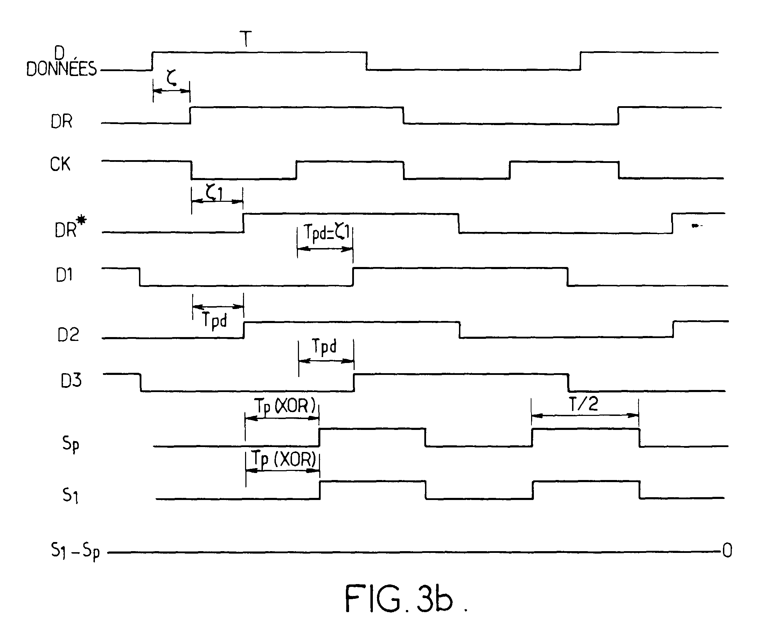

A l'équilibre, c'est-à-dire en l'absence de déphasage entre le signal d'horloge Ck et le signal numérique retardé DR, un chronogramme des signaux correspondants est représenté en figure 3b.

Sur la figure 3b précitée, on indique que les deux circuits de type OU exclusif 111 et 211 ont même temps de propagation = Tp(XOR), les trois bascules bistables synchronisées 110, 20, 210 ont même temps de propagation = TpD,

$$\tau_1 = TpD$$

- la valeur du retard $\tau$ introduit par le circuit de retard 10 est quelconque et fixée dans les conditions précédemment données dans la description.

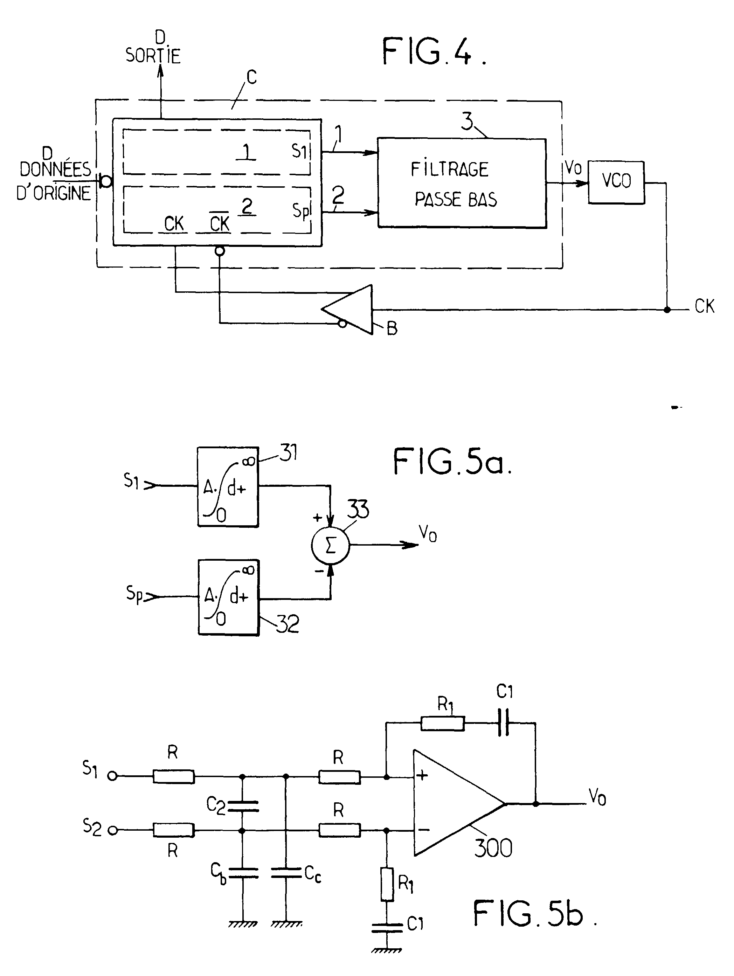

Une application particulièrement avantageuse du dispositif comparateur de phase, objet de la présente invention, sera maintenant décrite en liaison avec la figure 4.

Parmi toutes les applications envisageables du dispositif selon l'invention, une application très importante concerne l'utilisation de ce dernier dans une boucle de verrouillage de phase, une telle boucle étant constituée afin d'extraire un signal d'horloge local à partir d'un signal numérique d'entrée de données, dit signal de données d'origine.

De manière classique, ainsi que représenté sur la figure 4, la boucle à verrouillage de phase peut comprendre un dispositif comparateur de phase, tel que décrit précédemment dans la description, portant la référence C, comprenant un circuit comparateur de phase proprement dit formé par la première et la deuxième voie de détection 1,2 et par un circuit de calcul de la valeur moyenne portant la référence 3. Le comparateur C peut alors être suivi d'un circuit de type oscillateur local contrôlé en tension, noté VCO, lequel reçoit sur son entrée de commande en tension le signal de détection de phase $V_0$, le circuit oscillateur local commandé en tension délivrant le signal d'horloge Ck. Ce signal d'horloge peut alors bien entendu être utilisé comme signal d'horloge local. La sortie du circuit oscillateur local commandé en tension VCO est alors rebouclée sur les entrées de signal d'horloge Ck et de signal d'horloge $\overline{Ck}$ complémenté, par l'intermédiaire d'un circuit de mise en forme, noté B, ce circuit délivrant classiquement le signal d'horloge et le signal d'horloge complémenté. Ce circuit peut être un circuit de type classique réalisant les fonctions d'une bascule bistable par exemple.

Le signal D sortie est le signal numérique d'entrée resynchronisé sur le signal d'horloge Ck et peut être pris sur l'une des sorties précitées des trois bascules bistables synchronisées 110, 20, 210.

Dans le cas d'une application haute fréquence ou haut débit, le circuit de retard 112 pourra avantageusement être réalisé à l'aide de deux bascules verrouillées "*latches*", montées en mode transparent. On assure ainsi que le retard $\tau_1$ est idéalement appairé avec le temps de propagation des trois bascules bistables synchronisées précitées lorsque celles-ci sont formées de manière identique par deux bascules verrouillées.

En ce qui concerne le circuit 3, on indique que celui-ci peut délivrer un signal correspondant, soit à une tension, soit à un courant, lequel permet de commander l'oscillateur VCO.

L'oscillateur précité est choisi de façon à présenter une fréquence centrale très stable et peut donc être constitué par un oscillateur à cristal par exemple.

Le circuit 3 de calcul de la valeur moyenne constitue en fait un circuit de type filtre passe-bas assurant les fonctions d'intégration et de sommation algébrique des signaux de première et deuxième impulsion $S_1$, $S_p$ délivrés par la première, respectivement la deuxième voie de détection 1,2.

A ce titre, il peut comporter, ainsi que représenté en figure 5a, un premier et un deuxième circuit intégrateur 31, 32 recevant respectivement la première et la deuxième impulsion $S_1$, $S_p$ et délivrant un signal correspondant intégré, et un circuit soustracteur 33 recevant sur ses entrées positive respectivement négative le signal intégré délivré par le premier respectivement le deuxième circuit intégrateur 31,32. Le circuit soustracteur 33 délivre le signal de comparaison de phase $V_0$.

En ce qui concerne la réalisation pratique du circuit 3 et afin de réaliser les fonctions représentées en figure 5a, ce type de circuit pourra être réalisé, ainsi que représenté en figure 5b, à partir d'un amplificateur opérationnel 300 monté en amplificateur différentiel et rebouclé en contre-réaction par l'intermédiaire d'un circuit série $R_1C_1$ sur l'entrée négative de ce dernier.

D'une manière générale, on indique que le dispositif comparateur de phase, objet de la présente invention, est particulièrement adapté à un fonctionnement à partir de données constituées par un signal numérique de type NRZ pour "*non return to zero*" en langage anglo-saxon. Toutefois, le dispositif comparateur de phase selon l'invention, en raison du fait que celui-ci est adapté à détecter des transitions, peut être utilisé avec tous types de formats de codage de signaux numériques, tels que codages de type RZ ou CMI par exemple.

## Revendications

1. Dispositif comparateur de phase entre transitions d'un signal numérique (D) formé par une suite de bits ak et un signal d'horloge (Ck) à la fréquence élément binaire de ce signal numérique, T désignant la période de ce dernier, caractérisé en ce que ledit dispositif comprend :

   - une première voie de detection (1) permettant, à partir dudit signal d'horloge (Ck) et dudit signal numérique, d'engendrer un signal numérique retardé (DR) d'une valeur de retard $\tau$ comprise entre $0 < \tau < T$, ladite première voie comportant en outre des moyens générateurs (110,111), à chaque transition du signal numérique, d'une première impulsion (S1) dont la durée est variable, proportionnelle au déphasage entre le signal numérique retardé et le signal d'horloge (Ck) ; et
   - une deuxième voie de détection (2) permettant, à partir dudit signal d'horloge (Ck) et dudit signal numérique, d'engendrer à chaque transition dudit signal numérique une deuxième impulsion (Sp) calibrée de durée constante égale à la demi-période dudit signal d'horloge Ck ;

- des moyens (3) de calcul de la valeur moyenne, sur au moins un cycle dudit signal d'horloge (Ck), de la différence algébrique entre la première et la deuxième impulsion, lesdits moyens de calcul délivrant un signal (Vo) de comparaison de phase entre signal numérique et signal d'horloge de valeur nulle pour un déphasage nul et un centrage exact de l'impulsion formée par deux transitions consécutives du signal numérique retardé sur un front montant ou descendant du signal d'horloge et de valeur positive ou négative pour un déphasage d'avance respectivement de retard du signal d'horloge (Ck) par rapport au signal numérique retardé.

2. Dispositif selon la revendication 1, caractérisé en ce que ladite première voie comprend, connectés en cascade :

   - un circuit de retard (10) de la valeur de retard $\tau$ déterminée,
   - lesdits moyens générateurs de ladite première impulsion comprenant :

     . un premier circuit logique (111) de type OU exclusif recevant sur une première entrée ledit signal numérique retardé, et
     . une bascule bistable (110) synchronisée sur ledit signal d'horloge (Ck) recevant sur son entrée ledit signal numérique retardé et délivrant en sortie un signal (D1) numérique retardé synchronisé, une deuxième entrée dudit premier circuit OU exclusif étant connectée en sortie de ladite bascule bistable synchronisée, ledit premier circuit OU exclusif délivrant ladite première impulsion (S1).

3. Dispositif selon la revendication 1 ou 2, caractérisé en ce que ladite deuxième voie (2)) comprend, connectés en cascade :

   - des moyens générateurs, à partir dudit signal numérique d'entrée, d'un signal numérique décalé d'une demi-période par rapport audit signal numérique retardé synchronisé, et
   - des moyens générateurs, à partir dudit signal numérique retardé d'une demi-période, de ladite deuxième impulsion comprenant :

     . un deuxième circuit logique (211) de type OU exclusif recevant sur une première entrée ledit signal numérique décalé d'une demi-période,
     . une bascule bistable (210) synchronisée sur ledit signal d'horloge (Ck) recevant sur son entrée ledit signal logique décalé d'une demi-période, une deuxième entrée dudit deuxième circuit OU exclusif étant connectée en sortie de ladite bascule bistable synchronisée, ledit deuxième circuit OU exclusif délivrant ladite deuxième impulsion (Sp).

4. Dispositif selon la revendication 3, caractérisé en ce que lesdits moyens générateurs, à partir dudit signal numérique d'entrée, d'un signal numérique décalé d'une demi-période par rapport audit signal numérique retardé synchronisé, comprennent une bascule bistable (20) synchronisée sur ledit signal d'horloge complémenté ($\overline{Ck}$) recevant sur son entrée D ledit signal numérique d'entrée et délivrant sur sa sortie Q ledit signal numérique décalé d'une demi-période.

5. Dispositif selon l'une des revendications 2 à 4, caractérisé en ce que, en vue d'une application à hautes fréquences ou à haut débit, ladite première entrée dudit premier circuit logique de type OU exclusif comprend un circuit de retard (112) permettant d'introduire une compensation sur le signal numérique retardé du temps de propagation et de transition introduit par ladite première bascule bistable synchronisée.

6. Dispositif selon l'une des revendications précédentes, caractérisé en ce que lesdits moyens de calcul de la valeur moyenne comprennent :

   - un premier et un deuxième circuit intégrateur (31,32) recevant en entrée ladite première respectivement deuxième impulsion et délivrant chacun un signal correspondant intégré,
   - un circuit soustracteur (33) recevant sur ses entrées positive respectivement négative le signal intégré délivré par le premier respectivement le deuxième circuit intégrateur et délivrant ledit signal de comparaison de phase.

7. Utilisation d'un dispositif comparateur de phase selon l'une des revendications précédentes pour réaliser une boucle à verrouillage de phase pour reconstituer un signal d'horloge série (Ck) à partir d'un signal numérique d'entrée (D).

**Patentansprüche**

1. Komparatorvorrichtung für die Phase zwischen Übergängen von einem von einer Folge von Bits ak gebildeten numerischen Signal (D) und einem Taktsignal (Ck) zur Bitfrequenz dieses numerischen Signals, wobei T dessen Periode bezeichnet, dadurch gekennzeichnet, daß die Vorrichtung umfaßt:

- einen ersten Detektionspfad (1), der es ermöglicht, ausgehend von dem Taktsignal (Ck) und dem numerischen Signal ein verzögertes numerisches Signal (DR) mit einem Verzögerungswert τ zwischen 0 < τ < T zu erzeugen, wobei der erste Pfad weiterhin Mittel (110, 111) zur Erzeugung eines ersten Impulses (51) bei jedem Übergang des numerischen Signals aufweist, wobei die Dauer des Impulses variabel und dieser proportional zur Phasenverschiebung zwischen dem verzögerten numerischen Signal und dem Taktsignal (Ck) ist; und
- einen zweiten Detektionspfad (2), der es ermöglicht, ausgehend von dem Taktsignal (Ck) und dem numerischen Signal bei jedem Übergang des numerischen Signals einen kalibrierten zweiten Impuls konstanter Dauer, die gleich der Halbperiode des Taktsignals Ck ist, zu erzeugen,
- Mittel (3) zum Berechnen des Mittelwerts der algebraischen Differenz zwischen dem ersten und zweiten Impuls in wenigstens einem Zyklus des Taktsignals (Ck), wobei die Mittel zum Berechnen ein Signal (Vo) in Abhängigkeit des Phasenvergleichs zwischen numerischem Signal und Taktsignal liefern, und zwar mit dem Wert Null bei einer Phasenverschiebung von Null und einer genauen Zentrierung des Impulses, der durch zwei aufeinanderfolgende Übergänge des verzögerten numerischen Signals gebildet wird, auf einer steigenden oder fallenden Flanke des Taktsignals und mit positivem oder negativem Wert bei einer vor- beziehungsweise nacheilenden Phasenverschiebung des Taktsignals (Ck) im Verhältnis zum verzögerten numerischen Signal.

2. Vorrichtung nach Anspruch 1, dadurch gekennzeichnet, daß der erste Pfad in kaskadenförmiger Schaltung

   - eine Verzögerungsschaltung (10) mit dem bestimmten Verzögerungswert τ umfaßt,
   - wobei die Erzeugermittel des ersten Impulses umfassen:

     • einen ersten Exklusiv-ODER-Logikschaltkreis (111), der an einem ersten Eingang das verzögerte numerische Signal empfängt, und
     • ein mit dem Taktsignal (Ck) synchronisiertes, bistabiles Kippglied (110), welches eingangsseitig das verzögerte numerische Signal empfängt und ausgangsseitig ein synchronisiertes, verzögertes numerisches Signal liefert, wobei ein zweiter Eingang des ersten Exklusiv-ODER-Schaltkreises mit dem Ausgang des synchronisierten bistabilen Kippglieds verbunden ist, wobei der erste Exklusiv-ODER-Schaltkreis den ersten Impuls (S1) liefert.

3. Vorrichtung nach Anspruch 1 oder 2, dadurch gekennzeichnet, daß der zweite Pfad (2) in kaskadenförmiger Schaltung umfaßt:

   - Mittel zum Erzeugen eines im Verhältnis zum synchronisierten, verzögerten numerischen Signal um eine Halbperiode verschobenen numerischen Signals ausgehend von dem numerischen Eingangssignal und
   - Mittel zum Erzeugen des zweiten Impulses ausgehend von dem um eine Halbperiode verzögerten Signal umfassend:

     • einen zweiten Exklusiv-ODER-Logikschaltkreis (211), der an einem ersten Eingang das um eine Halbperiode verschobene numerische Signal empfängt,
     • ein mit dem Taktsignal (Ck) synchronisiertes bistabiles Kippglied (210), das eingangsseitig das um eine Halbperiode verschobene Logiksignal empfängt, wobei ein zweiter Eingang des zweiten Exklusiv-ODER-Schaltkreises mit dem Ausgang des synchronisierten bistabilen Kippglieds verbunden ist, wobei der zweite Exklusiv-ODER-Schaltkreis den zweiten Impuls (Sp) liefert.

4. Vorrichtung nach Anspruch 3, dadurch gekennzeichnet, daß die Mittel zum Erzeugen eines im Verhältnis zu dem synchronisierten, verzögerten numerischen Signal um eine Halbperiode verschobenen numerischen Signals ausgehend von dem numerischen Eingangssignal ein mit dem komplementären Taktsignal ($\overline{Ck}$) synchronisiertes bistabiles Kippglied (20) umfassen, das an seinem Eingang D das numerische Eingangssignal empfängt und an seinem Ausgang Q das um eine Halbperiode verschobene numerische Signal liefert.

5. Vorrichtung nach einem der Ansprüche 2 bis 4, dadurch gekennzeichnet, daß im Hinblick auf einen Einsatz bei hohen Frequenzen oder mit hoher Leistung der erste Eingang des ersten Exklusiv-ODER-Logikschaltkreises einen Verzögerungsschaltkreis (112) umfaßt, der es ermöglicht, auf das von dem ersten synchronisierten bistabilen Kippglied eingeführte, um die Ausbreitungs- und Übergangszeit verzögerte numerische Signal eine Kompensation anzuwenden.

6. Vorrichtung nach einem der vorhergehenden Ansprüche, dadurch gekennzeichnet, daß die Mittel zum Berechnen des Mittelwertes umfassen:

- einen ersten und einen zweiten Integrierschaltkreis (31, 33), der eingangsseitig den ersten beziehungsweise zweiten Impuls empfängt und jeweils ein entsprechendes integriertes Signal liefert,
- einen Subtraktionsschaltkreis (33), der an seinem positiven Eingang beziehungsweise seinem negativen Eingang das von dem ersten beziehungsweise zweiten Integrierschaltkreis gelieferte integrierte Signal empfängt und das Phasenvergleichssignal liefert.

7. Verwendung einer Phasenkomparatorvorrichtung nach einem der vorhergehenden Ansprüche zum Erstellen einer Phasenverriegelungsschleife zum Wiederherstellen eines seriellen Taktsignals (Ck) ausgehend von einem numerischen Eingangssignal (D).

**Claims**

1. Device for phase comparison between transitions of a digital signal (D) formed by a series of bits (ak) and a clock signal (Ck) at the binary element frequency of this digital signal, T being the cycle of the latter, characterised by the fact that the said device comprises:

    a first detection channel (1) permitting generation, from the said clock signal (Ck) and the said digital signal, of a delayed digital signal (DR) with a delay value τ between 0 < τ < T, the said first channel also including means for generating (110,111), at each transition of the digital signal, a first pulse (S1) of variable duration, proportional to the phase difference between the delayed digital signal and the clock signal (Ck); and
    a second detection channel (2) permitting generation, from the said clock signal (Ck) and the said digital signal, at each transition of the said digital signal of a second calibrated pulse (Sp) of constant duration equal to the half-cycle of the said clock signal (Ck) ;
    means (3) for calculating the average value, over at least one cycle of the said clock signal (Ck), of the algebraic difference between the first and the second pulse, the said calculating means producing a phase comparison signal (Vo) between digital signal and clock signal of zero value for a zero phase difference and exact centring of the pulse formed by two consecutive transitions of the delayed digital signal on a rising or falling edge of the clock signal and of positive or negative value for a leading or lagging phase difference respectively of the clock signal (Ck) relative to the delayed digital signal.

2. Device as described in claim 1, characterised by the fact that the said first channel comprises, connected in cascade:
    a delay circuit (10) of the determined delay value τ, the said means for generating the said first pulse comprising:

    a first logic circuit (111) of the NOR type receiving the said delayed digital signal at a first input, and
    a bistable flip-flop (110) synchronised with the said clock signal (Ck) receiving at its input the said delayed digital signal and producing at its output a synchronised delayed digital signal (D1), a second input of the said first NOR circuit being connected to the output of the said synchronised bistable flip-flop, the said first NOR circuit producing the said first pulse (S1).

3. Device as described in claim 1 or 2, characterised by the fact that the said second channel (2) comprises connected in cascade:

    means for generating, from the said digital input signal, a digital signal shifted by half a cycle relative to the said synchronised delayed digital signal, and
    means for generating, from the said digital signal delayed by half a cycle, the said second pulse comprising:

    a second logic circuit (211) of the NOR type receiving at a first input the said digital signal shifted by half a cycle,
    a bistable flip-flop (210) synchronised with the said clock signal (Ck) receiving at its input the said logic signal shifted by half a cycle, a second input of the said second NOR circuit being connected to the output of the said synchronised bistable flip-flop, the said second NOR circuit producing the said second pulse (Sp).

4. Device as described in claim 3, characterised by the fact that the said means for generating, from the said digital input signal, a digital signal shifted by half a cycle relative to the said synchronised delayed digital signal, comprise a bistable flip-flop (20) synchronised with the said complemented clock signal ($\overline{Ck}$) receiving at its input (D) the said digital input signal and producing at its output (Q) the said digital signal shifted by half a cycle.

5. Device as described in one of claims 2 to 4, characterised by the fact that, for an application at high frequency or high flow rate, the said first input of the said first logic circuit of NOR type comprises a delay circuit (112) allowing introduction of a compensation to the delayed digital signal for the propagation and transition time introduced by the said first synchronised bistable flip-flop.

6.  Device as described in one of the preceding claims, characterised by the fact that the said means for calculating the average value comprise:

    a first and a second summation circuit (31,32) receiving at their inputs the said first and second pulses respectively and each producing a corresponding summated signal,
    a subtraction circuit (33) receiving at its positive and negative inputs respectively the summated signal produced by the first and the second summation circuit respectively and producing the said phase comparison signal.

7.  Use of a phase comparison device as described in one of the preceding claims to produce a phase locking loop to recreate a serial clock signal (Ck) from a digital input signal (D).

COMPARATEUR DE HOGGE, A L'ÉQUILIBRE

# FIG.1. (ART ANTERIEUR)

# FIG. 2a.

FIG.2b . HORLOGE EN AVANCE

FIG.2c . HORLOGE EN RETARD

FIG. 2d.   HORLOGE ET DONNÉES RETARDÉES EN PHASE

FIG. 3a.

FIG. 3b.

# FIG.4.

# FIG.5a.

# FIG.5b.